# EUROPEAN PATENT APPLICATION

(11) **EP 4 297 205 A1**
(43) Date of publication of application: **27.12.2023**
(21) Application number: 22756304.6
(22) Date of filing: 18.02.2022
(51) Int. Cl.: H01S 5/0683, G02B 6/12, G02B 6/42

(54) **LIGHT EMITTING DEVICE**

(30) Priority: 19.02.2021 JP 2021025665
(71) Applicant: Kyocera Corporation, Kyoto-shi Kyoto 612-8501 (JP)
(72) Inventor: ITAKURA, Yoshiaki, Kyoto-shi, Kyoto 612-8501 (JP)
(74) Representative: Viering, Jentschura & Partner mbB Patent- und Rechtsanwälte
(86) International application number: PCT/JP2022/006736
(87) International publication number: WO 2022/176987

(57) **Abstract**

A light emitter includes a substrate including a first surface, a cladding on the first surface of the substrate, a core inside the cladding, a lid on the cladding, a first light-emitting element inside an element sealing area on the first surface, a second light-emitting element inside the element sealing area, and a light-receiving element inside the element sealing area.

## Description

### TECHNICAL FIELD

The present disclosure relates to a light emitter.

### BACKGROUND OF INVENTION

A known technique is described in, for example, Patent Literature 1.

### CITATION LIST

### PATENT LITERATURE

Patent Literature 1: Japanese Unexamined Patent Application Publication No. 2004-207911

### SUMMARY

In an aspect of the present disclosure, a light emitter includes a substrate including a first surface, a first light-emitting element inside an element sealing area on the first surface, a second light-emitting element inside the element sealing area, a cladding on the first surface, a first core inside the cladding to receive light from the first light-emitting element, a second core inside the cladding to receive light from the second light-emitting element, and a light-receiving element inside the element sealing area. The light-receiving element includes a light-receiving surface to receive light from the first light-emitting element and the second light-emitting element.

### BRIEF DESCRIPTION OF THE DRAWINGS

The objects, features, and advantages of the present disclosure will become more apparent from the following detailed description and the drawings.
FIG. 1 is an exploded perspective view of a light emitter according to an embodiment of the present disclosure.
FIG. 2 is a plan view of the light emitter in FIG. 1 without illustrating a lid.
FIG. 3 is a cross-sectional view of the light emitter taken along section line III-III in FIG. 2.
FIG. 4 is an enlarged cross-sectional view of a light emitter according to another embodiment of the present disclosure.
FIG. 5 is an enlarged cross-sectional view of a light emitter according to another embodiment of the present disclosure.
FIG. 6 is an enlarged cross-sectional view of a light emitter according to another embodiment of the present disclosure.
FIG. 7 is an enlarged cross-sectional view of a light emitter according to another embodiment of the present disclosure.
FIG. 8 is an enlarged cross-sectional view of a light emitter according to another embodiment of the present disclosure.
FIG. 9 is an enlarged cross-sectional view of a light emitter according to another embodiment of the present disclosure.
FIG. 10 is an enlarged cross-sectional view of a light emitter according to another embodiment of the present disclosure.
FIG. 11 is an enlarged cross-sectional view of a light emitter according to another embodiment of the present disclosure.
FIG. 12 is an enlarged cross-sectional view of a light emitter according to another embodiment of the present disclosure.
FIG. 13 is an enlarged cross-sectional view of a light emitter according to another embodiment of the present disclosure.
FIG. 14 is an enlarged cross-sectional view of a light emitter according to another embodiment of the present disclosure.
FIG. 15 is an enlarged cross-sectional view of a light emitter according to another embodiment of the present disclosure.
FIG. 16 is an enlarged cross-sectional view of a light emitter according to another embodiment of the present disclosure.

### DESCRIPTION OF EMBODIMENTS

A light emitter with the structure that forms the basis of the present disclosure includes a light source such as a light-emitting element, monitors the intensity of light emitted from the light source, and controls the emitted light to be an intended output. The intensity of light from the light source is monitored using the amount of light received by a light-receiving element in the light emitter.

Patent Literature 1 describes an optical unit that includes a diffraction grating on a light emission path of a light source and a light-receiving element to receive the emitted light reflected from the diffraction grating.

A light emitter may include multiple light-emitting elements. The light-emitting elements, for example, emit light with different wavelengths. The output of each light-emitting element is thus to be adjusted to achieve an intended color tone. To control outputs of multiple light-emitting elements using the structure described in Patent Literature 1, a diffraction grating is to be located on the light emission path of each light-emitting element to reflect light, which is to be received by a light-receiving element for each light-emitting element. Alight emitter with this structure includes multiple diffraction gratings and multiple light-receiving elements and thus cannot be smaller.

In one or more embodiments of the present disclosure, a light emitter includes a substrate including a first surface, a first light-emitting element inside an element sealing area on the first surface, a second light-emitting element inside the element sealing area, a cladding on the first surface, a first core inside the cladding to receive light from the first light-emitting element, a second core inside the cladding to receive light from the second light-emitting element, and a light-receiving element inside the element sealing area. The light-receiving element includes a light-receiving surface to receive light from the first light-emitting element and the second light-emitting element.

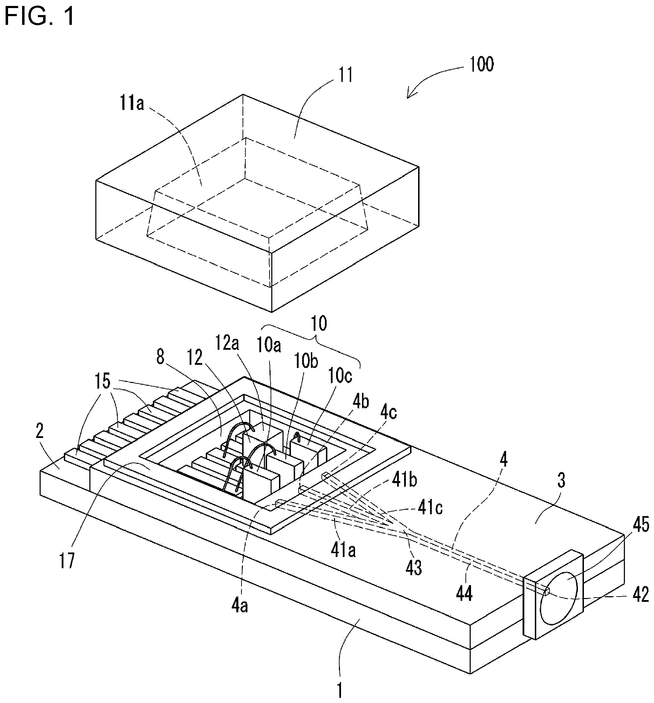

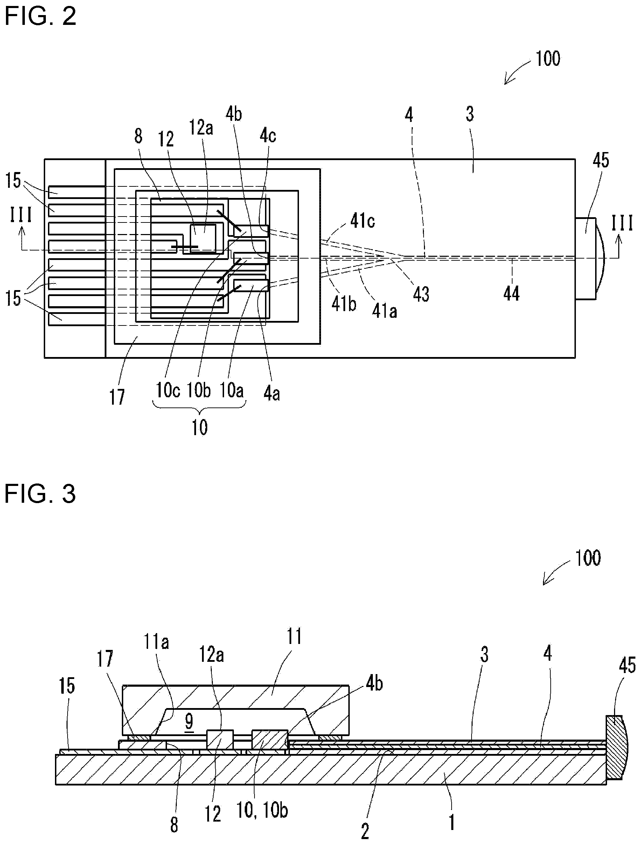

A light emitter according to one or more embodiments of the present disclosure will now be described with reference to the accompanying drawings. In the present embodiment, a light emitter 100 in FIGs. 1 to 3 includes a substrate 1 including a first surface 2, a cladding 3 on the first surface 2 of the substrate 1, a core 4 inside the cladding 3, a lid 11 on the cladding 3, a first light-emitting element 10a inside an element sealing area 9 on the first surface 2, a second light-emitting element 10b inside the element sealing area 9, and a light-receiving element 12 inside the element sealing area 9.

In the present embodiment, the light emitter 100 includes a third light-emitting element 10c in addition to the first light-emitting element 10a and the second light-emitting element 10b. The first light-emitting element 10a may be a laser diode that emits, for example, red (R) light. The second light-emitting element 10b may be a laser diode that emits green (G) light. The third light-emitting element 10c may be a laser diode that emits blue (B) light. The first light-emitting element 10a, the second light-emitting element 10b, and the third light-emitting element 10c may be collectively referred to as light-emitting elements 10. The light-receiving element 12 includes a light-receiving surface 12a to receive light from the first light-emitting element 10a and the second light-emitting element 10b. The light-receiving surface 12a of the light-receiving element 12 in the present embodiment also receives light from the third light-emitting element 10c. The light-receiving element 12 may be a photodiode.

The substrate 1 may be a ceramic wiring board including dielectric layers made of a ceramic material. Examples of the ceramic material used for the ceramic wiring board include sintered aluminum oxide, sintered mullite, sintered silicon carbide, sintered aluminum nitride, and sintered glass ceramic. For the substrate 1 being a ceramic wiring board, the dielectric layers include conductors such as connection pads, internal wiring conductors, and external connection terminals for electrical connection between the light-emitting and light-receiving elements and an external circuit.

The substrate 1 may be an organic wiring board including dielectric layers made of an organic material. The organic wiring board may be a printed wiring board, a build-up wiring board, or a flexible wiring board. Examples of the organic material used for the organic wiring board include an epoxy resin, a polyimide resin, a polyester resin, an acrylic resin, a phenolic resin, and a fluororesin.

The cladding 3 and the core 4 together serve as an optical waveguide. Both the cladding 3 and the core 4 may be made of glass such as quartz or a resin. In some embodiments, one of the cladding 3 or the core 4 may be made of glass, and the other of the cladding 3 or the core 4 may be made of a resin. The cladding 3 and the core 4 have different refractive indexes. The core 4 has a higher refractive index than the cladding 3. The difference in the refractive index causes total internal reflection of light in the core 4. With the waveguide (core 4) made of a material with a higher refractive index and surrounded by a material with a lower refractive index (cladding 3), light travels through the waveguide with a higher refractive index.

The core 4 includes a first core 41a to receive light from the first light-emitting element 10a, a second core 41b to receive light from the second light-emitting element 10b, a third core 41c to receive light from the third light-emitting element 10c, a merging point 43 that merges the first core 41a, the second core 41b, and the third core 41c, and a joining path 44 that includes an emission end face 42. The first core 41a includes an incident end face 4a. The second core 41b includes an incident end face 4b. The third core 41c includes an incident end face 4c. Light from the first light-emitting element 10a, light from the second light-emitting element 10b, and light from the third light-emitting element 10c travel through the first core 41a, the second core 41b, and the third core 41c and are emitted as combined light through the emission end face 42 of the joining path 44. A lens 45 is located on the optical path of light emitted from the core 4 and may collimate or condense light from the core 4. The lens 45 is, for example, a plano-convex lens with a straight incident surface and a convex emission surface.

The cladding 3 includes a portion surrounding the light-emitting elements 10 and the light-receiving element 12 mounted on the first surface 2 of the substrate 1. The cladding 3 in the present embodiment may include a through-hole 8. The first light-emitting element 10a, the second light-emitting element 10b, the third light-emitting element 10c, and the light-receiving element 12 are located in the through-hole 8. The element sealing area 9 in the present embodiment is a space surrounded by the substrate 1, the cladding 3, and the lid 11. The lid 11 in the present embodiment includes a recess 11a. The element sealing area 9 is a space including the through-hole 8. For example, when the cladding 3 is thick enough for the through-hole 8 to accommodate the light-emitting elements 10 and the light-receiving element 12, the lid 11 may be flat. When the light-emitting elements 10 and the light-receiving element 12 have heights greater than the thickness of the cladding 3, the lid 11 may include the recess 11a.

The light-receiving surface 12a of the light-receiving element 12 faces the lid 11. The core 4 receives light emitted from the first light-emitting element 10a, the second light-emitting element 10b, and the third light-emitting element 10c. The light-receiving surface 12a of the light-receiving element 12 receives, inside the element sealing area 9, light that is not received by the core 4 and light emitted through reflective surfaces opposite to emission surfaces of the light-emitting elements. For example, the light-receiving surface 12a receives light reflected from the inner peripheral surface of the through-hole 8 in the cladding 3 or from the inner surface of the lid 11. The lid 11 in the present embodiment includes the recess 11a. In this case, the light-receiving surface 12a receives light reflected from the inner surface of the recess 11a. The light emitter 100 with the above structure includes a single light-receiving element 12 to receive light from multiple light-emitting elements 10 and thus can be smaller. The light-receiving element 12 may have an area of 0.4 mm square including the light-receiving surface 120, and a height (thickness) of 0.2 mm.

In the present embodiment, the light-emitting elements 10 and the light-receiving element 12 are connected to external wires 15. The external wires 15 may extend from inside the element sealing area 9 to outside the element sealing area 9. The light-emitting elements 10 and the light-receiving element 12 include, on their lower surfaces, electrodes directly connected to the external wires 15 and, on their lower surfaces, electrodes connected to the external wires 15 with, for example, bonding wires. The light-emitting elements 10 and the light-receiving element 12 are electrically connected to an external control circuit through, for example, the external wires 15.

In the present embodiment, the external control circuit may control, for example, the light emission timing for the light emitter 100 to emit light from one of the first light-emitting element 10a, the second light-emitting element 10b, or the third light-emitting element 10c. The light-receiving element 12 receives light emitted at the light emission timing. The control circuit can adjust outputs of the light-emitting elements 10 based on the amount of light received by the light-receiving element 12, and adjust a current supplied to each light-emitting element based on the amount of the received light to adjust emitted light to an intended color. The control circuit may control the light emission timing for the light emitter 100 to simultaneously emit light from the first light-emitting element 10a, the second light-emitting element 10b, and the third light-emitting element 10c. In this case, the light-receiving element 12 receives light from all the light-emitting elements and outputs the amount of received light. The control circuit may adjust, for example, a current supplied to each light-emitting element based on the amount of received light.

The light emitter 100 may include a sealing metal film 17 on a portion (facing portion) of the cladding 3 facing the lid 11. The facing portion is between the upper surface of the cladding 3 and the lower surface of the lid 11 surrounding the recess 11a. The sealing metal film 17 may be made of a metal material and be a continuous loop surrounding the through-hole 8 in a plan view. The light emitter 100 with the sealing metal film 17 is highly hermetic inside the element sealing area 9.

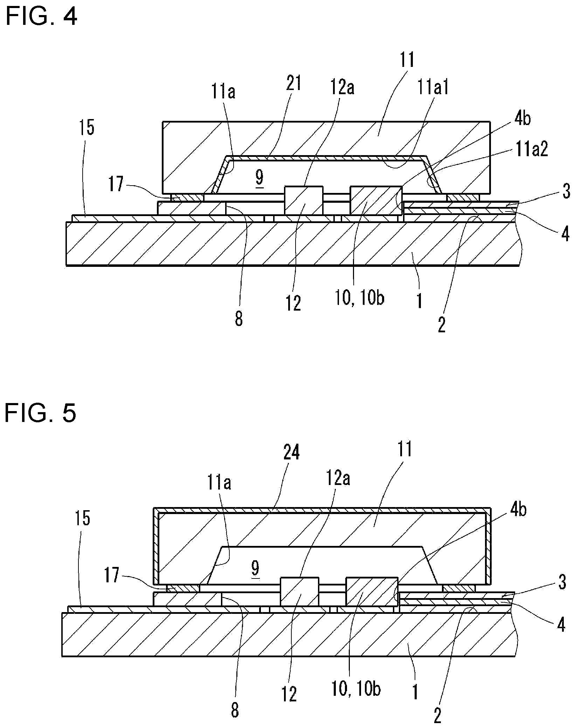

FIG. 4 is an enlarged cross-sectional view of a light emitter according to another embodiment of the present disclosure. FIG. 4 is an enlarged view of a portion near the element sealing area 9. The same reference numerals denote the components corresponding to those in the above embodiment, and such components will not be described repeatedly. In the present embodiment, the lid 11 includes a first reflective film 21 on the inner surface of the recess 11a. The recess 11a includes a bottom 11a1 and sides 11a2 on its inner surface. The first reflective film 21 is located on the bottom 11a1 and the sides 11a2. The first reflective film 21 may be a metal film of, for example, aluminum, chromium, gold, or titanium, or a dielectric multilayer film. Light reaching the inner surface of the recess 11a on the lid 11 is partly reflected, partly transmitted through the lid 11, and partly absorbed by the lid 11. The lid 11 with the first reflective film 21 increases the amount of light reflected inside the element sealing area 9, thus increasing the amount of light received by the light-receiving element 12. With the light-receiving element 12 receiving an increased amount of light, the light emitter 100 can control the light-emitting elements 10 more precisely and thus can adjust the color tone more precisely. The lid 11 being a flat plate may include the first reflective film 21 on the surface (lower surface) of the lid 11 facing the substrate 1. The first reflective film 21 is at least located on a portion of the lower surface of the lid 11 facing the element sealing area 9.

FIG. 5 is an enlarged cross-sectional view of a light emitter according to another embodiment of the present disclosure. FIG. 5 is an enlarged view of a portion near the element sealing area 9. The same reference numerals denote the components corresponding to those in the above embodiment, and such components will not be described repeatedly. In the present embodiment, the lid 11 is transparent and includes a fourth reflective film 24 on its outer surface. The transparent lid 11 may transmit light emitted from any of the first light-emitting element 10a, the second light-emitting element 10b, or the third light-emitting element 10c. The fourth reflective film 24 may be a metal film of, for example, aluminum, chromium, gold, or titanium, or a dielectric multilayer film. Light reaching the inner surface of the lid 11 is partly reflected, partly transmitted through the lid 11, and partly absorbed by the lid 11. The lid 11 reflects, with the fourth reflective film 24 included in the lid 11, light transmitted through the lid 11 to inside the element sealing area 9, thus increasing the amount of light received by the light-receiving element 12.

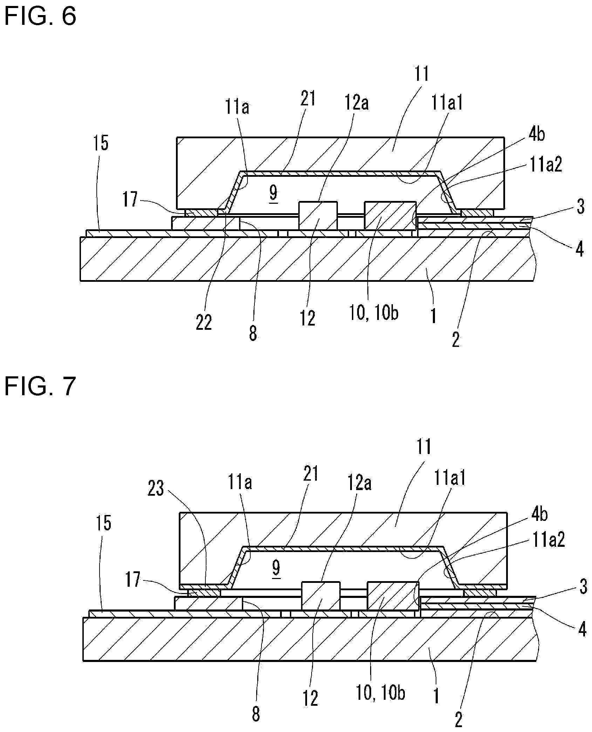

FIG. 6 is an enlarged cross-sectional view of a light emitter according to another embodiment of the present disclosure. FIG. 6 is an enlarged view of a portion near the element sealing area 9. The same reference numerals denote the components corresponding to those in the above embodiment, and such components will not be described repeatedly. In the present embodiment, the lid 11 includes, inward from the sealing metal film 17, a second reflective film 22 continuous with the first reflective film 21. The second reflective film 22 may be, similarly to the first reflective film 21, a metal film of, for example, aluminum, chromium, gold, or titanium, or a dielectric multilayer film. When light travels inside the element sealing area 9, light reaching the first reflective film 21 is reflected from the first reflective film 21, light reaching the sealing metal film 17 is reflected from the sealing metal film 17, and light transmitted through the lid 11 or absorbed by the lid 11 leaks. The second reflective film 22 can reflect light that reaches a portion between the first reflective film 21 and the sealing metal film 17, thus reducing light leakage and increasing the amount of light received by the light-receiving element 12.

FIG. 7 is an enlarged cross-sectional view of a light emitter according to another embodiment of the present disclosure. FIG. 7 is an enlarged view of a portion near the element sealing area 9. The same reference numerals denote the components corresponding to those in the above embodiment, and such components will not be described repeatedly. In the present embodiment, the lid 11 includes a third reflective film 23 on its portion facing the cladding 3 and continuous with the first reflective film 21. The third reflective film 23 is located on the lower surface of the lid 11 surrounding the recess 11a and overlaps the sealing metal film 17 in a transparent plan view. The third reflective film 23 may be, similarly to the first reflective film 21, a metal film of, for example, aluminum, chromium, gold, or titanium, or a dielectric multilayer film. The third reflective film 23 can reflect, similarly to the second reflective film 22, light that reaches a portion between the first reflective film 21 and the sealing metal film 17, thus reducing light leakage and increasing the amount of light received by the light-receiving element 12. The lid 11 can be firmly bonded to the sealing metal film 17 by bonding the third reflective film 23 to the sealing metal film 17.

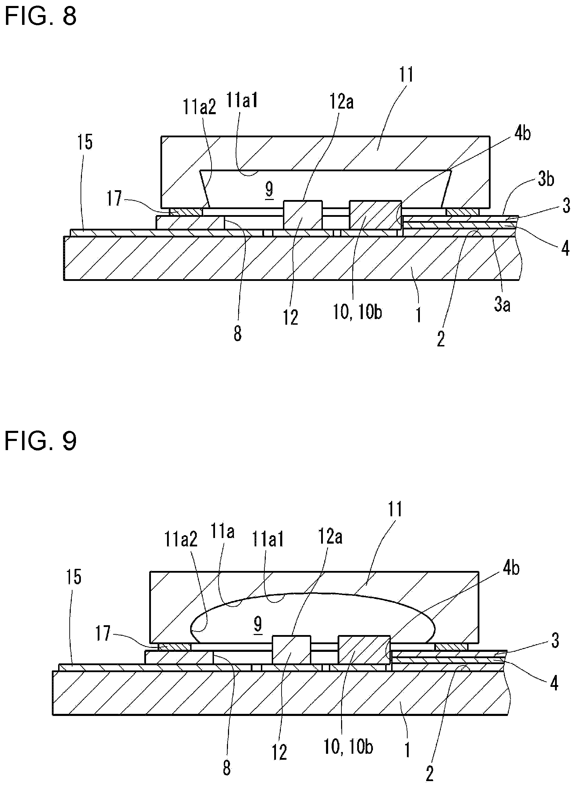

FIG. 8 is an enlarged cross-sectional view of a light emitter according to another embodiment of the present disclosure. FIG. 8 is an enlarged view of a portion near the element sealing area 9. The same reference numerals denote the components corresponding to those in the above embodiment, and such components will not be described repeatedly. In the present embodiment, the recess 11a on the lid 11 includes the bottom 11a1 and the sides 11a2 on its inner surface, with the sides 11a2 sloping outward at greater distances from the cladding 3. The light-receiving surface 12a of the light-receiving element 12 in the present embodiment faces the lid 11 and thus easily receives light reflected from the bottom 11a1 when light travels inside the element sealing area 9. The sides 11a2 of the recess 11a slope as described above and thus easily reflect light reaching the sides 11a2 to the bottom 11a1, increasing the amount of light received by the light-receiving element 12. The lid 11 in FIG. 8 does not include the reflective films 21, 22, and 23, but may include the reflective films 21, 22, and 23.

FIG. 9 is an enlarged cross-sectional view of a light emitter according to another embodiment of the present disclosure. FIG. 9 is an enlarged view of a portion near the element sealing area 9. The same reference numerals denote the components corresponding to those in the above embodiment, and such components will not be described repeatedly. In the present embodiment, the recess 11a includes a dome-shaped inner surface. In this structure, the curved surface reflects light reaching the dome-shaped inner surface inside the element sealing area 9, thus increasing the amount of light received by the light-receiving element 12. The curved surface may have the shape of a concave lens to focus the reflected light on the light-receiving surface 12a to increase the amount of light received by the light-receiving element 12. In FIG. 9, the sides 11a2 slope outward at greater distances from the cladding 3. The sides 11a2 may extend perpendicularly to the cladding 3, or slope inward from the cladding 3. The lid 11 in FIG. 9 does not include the reflective films 21, 22, and 23, but may include the reflective films 21, 22, and 23. The lid 11 in FIG. 9 does not include the reflective films 21, 22, and 23, but may include the reflective films 21, 22, and 23.

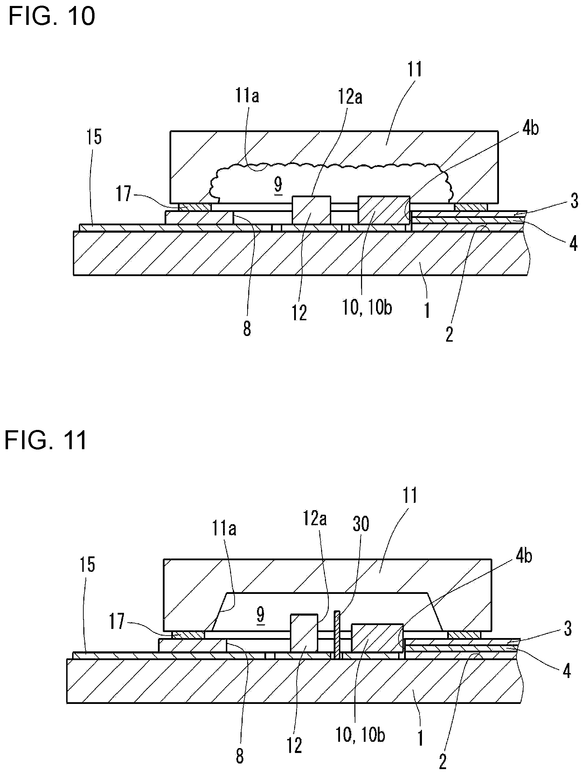

FIG. 10 is an enlarged cross-sectional view of a light emitter according to another embodiment of the present disclosure. FIG. 10 is an enlarged view of a portion near the element sealing area 9. The same reference numerals denote the components corresponding to those in the above embodiment, and such components will not be described repeatedly. In the present embodiment, the recess 11a includes a roughened surface included in its inner surface. The roughened surface may have a roughness greater than the roughness of other surfaces such as outer surfaces. The roughened surface reflects and diffuses light reaching the roughened surface, thus increasing the amount of light received by light-receiving element 12. The lid 11 in FIG. 10 does not include the reflective films 21, 22, and 23, but may include the reflective films 21, 22, and 23.

FIG. 11 is an enlarged cross-sectional view of a light emitter according to another embodiment of the present disclosure. FIG. 11 is an enlarged view of a portion near the element sealing area 9. The same reference numerals denote the components corresponding to those in the above embodiment, and such components will not be described repeatedly. In the present embodiment, the light-receiving surface 12a of the light-receiving element 12 faces the light-emitting elements 10, unlike in the embodiments described above. The light-receiving surface 12a facing the light-emitting elements 10 receives light from the light-emitting elements 10 more directly than when receiving reflected light. The light-receiving surface 12a thus receives a comparatively large amount of light and may deteriorate more quickly than when receiving reflected light. When a single light-receiving element 12 directly receives light from multiple light-emitting elements 10, the positions of the light-receiving element 12 and the light-emitting elements 10 may not be easily adjusted. In contrast, the light emitter 100 according to the present embodiment includes a light diffuser 30 between the light-receiving element 12 and the light-emitting elements 10. The light diffuser 30 diffuses light from the light-emitting elements 10 to be received by the light-receiving element 12 inside the element sealing area 9. The position of the light diffuser 30 may be adjusted to cause the light-receiving element 12 to receive the diffused light from the light-emitting elements 10. With the light-receiving element 12 receiving the diffused light from the light-emitting elements 10, the amount of received light is reduced. The positions of the light-receiving element 12 and the light-emitting elements 10 are also easily adjustable. The light diffuser 30 is, for example, a diffraction grating.

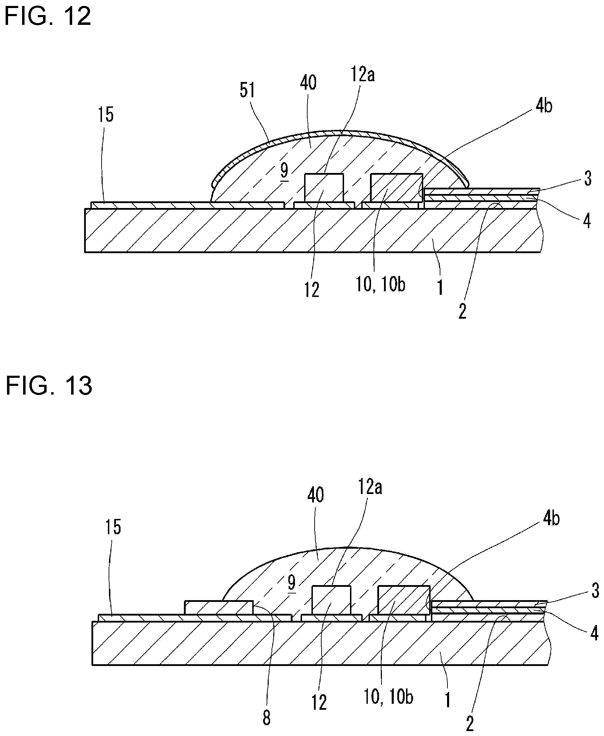

FIG. 12 is an enlarged cross-sectional view of a light emitter according to another embodiment of the present disclosure. FIG. 12 is an enlarged view of a portion near the element sealing area 9. The same reference numerals denote the components corresponding to those in the above embodiment, and such components will not be described repeatedly. The light emitter 100 according to the present embodiment does not include the lid 11, but includes a seal 40 that seals the light-emitting elements 10 and the light-receiving element 12. The seal 40 is included in the element sealing area 9 in the present embodiment. The seal 40 is transparent to light emitted from the light-emitting elements 10 to be received by the light-receiving element 12. The seal 40 may be any material transparent to light emitted from the light-emitting elements 10, such as a resin material or a glass material. The light-receiving surface 12a of the light-receiving element 12 is opposite to the surface facing the first surface 2 of the substrate 1. This structure is the same as the examples including the lid 11 described above.

When the element sealing area 9 includes the seal 40, the cladding 3 may not include a portion (through-hole 8) that surrounds the light-emitting elements 10 and the light-receiving element 12, unlike in the embodiments described above. The light-emitting elements 10 and the light-receiving element 12 may be mounted on the first surface 2 of the substrate 1, connected to the external wires 15, and sealed by the seal 40.

The light-receiving surface 12a of the light-receiving element 12 in the present embodiment receives light from the light-emitting elements 10 reflected at the boundary between the seal 40 and the external space. The light emitter 100 with the above structure includes a single light-receiving element 12 to receive light from the multiple light-emitting elements 10 and thus can be smaller.

When the seal 40 in the present embodiment is made of a transparent resin, moisture from the surrounding environment or outside air may permeate the transparent resin. The seal 40 thus includes a fifth reflective film 51 on its outer surface as illustrated in FIG. 12. The fifth reflective film 51 may be a metal film of, for example, aluminum, chromium, gold, or titanium, or a dielectric multilayer film. The fifth reflective film 51 can reduce the likelihood of moisture or outside air permeating the seal 40. The fifth reflective film 51 also reflects light, which is then received by the light-receiving surface 12a. The fifth reflective film 51 thus increases the amount of light reflected inside the seal 40, increasing the amount of light received by the light-receiving element 12. With the light-receiving element 12 receiving an increased amount of light, the light emitter 100 can control the light-emitting elements 10 more precisely and thus can adjust the color tone more precisely.

FIG. 13 is an enlarged cross-sectional view of a light emitter according to another embodiment of the present disclosure. FIG. 13 is an enlarged view of a portion near the element sealing area 9. The same reference numerals denote the components corresponding to those in the above embodiment, and such components will not be described repeatedly. In the present embodiment, the cladding 3 includes the through-hole 8 and surrounds the seal 40 in the direction along the first surface 2 of the substrate 1. The seal 40 in a softened or fluid state covers the light-emitting elements 10 and the light-receiving element 12 and then is cured. When the cladding 3 includes a portion surrounding the seal 40, such as the through-hole 8 as in the present embodiment, the cladding 3 can prevent the seal 40 in a softened or fluid state from flowing out of the cladding 3 during sealing and facilitate the formation of the seal 40.

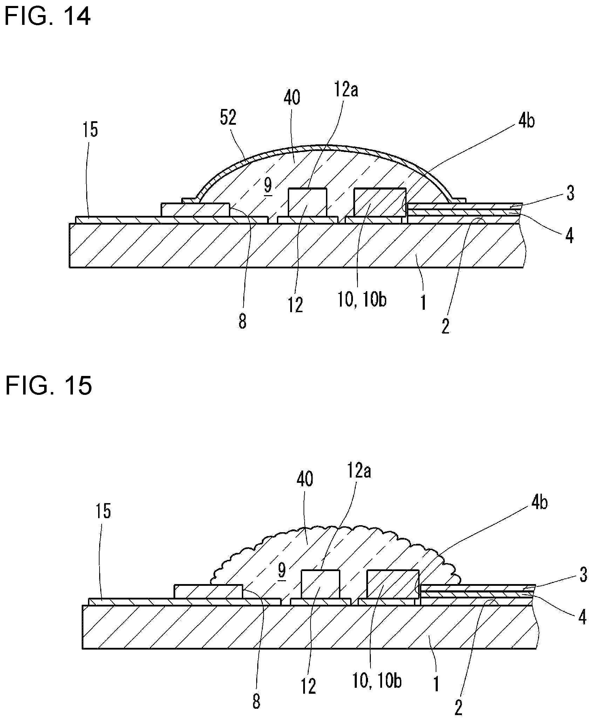

FIG. 14 is an enlarged cross-sectional view of a light emitter according to another embodiment of the present disclosure. FIG. 14 is an enlarged view of a portion near the element sealing area 9. The same reference numerals denote the components corresponding to those in the above embodiment, and such components will not be described repeatedly. In the present embodiment, the cladding 3 includes the through-hole 8, and a sixth reflective film 52 is located on the outer surface of the seal 40. The sixth reflective film 52 may be a metal film of, for example, aluminum, chromium, gold, or titanium, or a dielectric multilayer film. The sixth reflective film 52 extends from the outer surface of the seal 40 to the cladding 3. The seal 40 is thus surrounded by the cladding 3 and the sixth reflective film 52, reducing light leakage and increasing the amount of light received by the light-receiving element 12.

FIG. 15 is an enlarged cross-sectional view of a light emitter according to another embodiment of the present disclosure. FIG. 15 is an enlarged view of a portion near the element sealing area 9. The same reference numerals denote the components corresponding to those in the above embodiment, and such components will not be described repeatedly. In the present embodiment, the seal 40 includes a roughened surface included in its outer surface. The roughened surface may have a roughness greater than the roughness of other surfaces. The roughened surface reflects and diffuses light reaching the roughened surface, thus increasing the amount of light received by the light-receiving element 12. The seal 40 in FIG. 15 does not include the sixth reflective film 52, but may include the sixth reflective film 52.

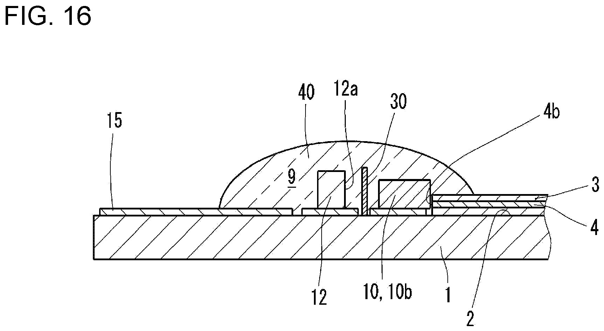

FIG. 16 is an enlarged cross-sectional view of a light emitter according to another embodiment of the present disclosure. FIG. 16 is an enlarged view of a portion near the element sealing area 9. The same reference numerals denote the components corresponding to those in the above embodiment, and such components will not be described repeatedly. In the present embodiment, the light-receiving surface 12a of the light-receiving element 12 faces the light-emitting elements 10, and the light diffuser 30 is located between the light-receiving element 12 and the light-emitting elements 10. The light diffuser 30 diffuses light from the light-emitting elements 10 to be received by the light-receiving element 12 inside the seal 40. The position of the light diffuser 30 may be adjusted to cause the light-receiving element 12 to receive the diffused light from the light-emitting elements 10. With the light-receiving element 12 receiving the diffused light from the light-emitting elements 10, the amount of received light is reduced. The positions of the light-receiving element 12 and the light-emitting elements 10 are also easily adjustable. The light diffuser 30 is, for example, a diffraction grating.

In still another embodiment of the present disclosure, the light-receiving surface 12a of the light-receiving element 12 may face the light-emitting elements 10, and reflectors such as mirrors may be located between the light-receiving element 12 and the light-emitting elements 10. The reflectors are located for their respective light-emitting elements 10 with an adjusted reflection angle. A first reflector reflects light from the first light-emitting element 10a to be received by the light-receiving element 12. A second reflector reflects light from the second light-emitting element 10b to be received by the light-receiving element 12. A third reflector reflects light from the third light-emitting element 10c to be received by the light-receiving element 12.

Although the embodiments of the present disclosure have been described in detail, the present disclosure is not limited to the embodiments described above, and may be changed or varied in various manners without departing from the spirit and scope of the present disclosure. The components described in the above embodiments may be entirely or partially combined as appropriate unless any contradiction arises.

### REFERENCE SIGNS

- 1: sub strate
- 2: first surface
- 3: cladding
- 4: core
- 4a, 4b, 4c: incident end face
- 8: through-hole
- 9: element sealing area
- 10: light-emitting element
- 10a: first light-emitting element
- 10b: second light-emitting element
- 10c: third light-emitting element
- 11: lid
- 11a: recess
- 11a1: bottom
- 11a2: side
- 12: light-receiving element
- 12a: light-receiving surface
- 15: external wire
- 17: sealing metal film
- 21: first reflective film
- 22: second reflective film
- 23: third reflective film
- 24: fourth reflective film
- 30: light diffuser
- 40: seal
- 41a: first core
- 41b: second core
- 41c: third core
- 42: emission end face
- 43: merging point
- 44: joining path
- 45: lens
- 51: fifth reflective film
- 52: sixth reflective film
- 100: light emitter

## Claims

1. A light emitter, comprising:
a substrate including a first surface;
a first light-emitting element inside an element sealing area on the first surface;
a second light-emitting element inside the element sealing area;
a cladding on the first surface;
a first core inside the cladding, the first core being configured to receive light from the first light-emitting element;
a second core inside the cladding, the second core being configured to receive light from the second light-emitting element; and
a light-receiving element inside the element sealing area, the light-receiving element including a light-receiving surface to receive light from the first light-emitting element and the second light-emitting element.

2. The light emitter according to claim 1, further comprising:
a lid,
wherein the lid is on the cladding,
the element sealing area is a space surrounded by at least the cladding and the lid, and
the light-receiving surface faces the lid.

3. The light emitter according to claim 2, wherein
the lid includes a recess.

4. The light emitter according to claim 3, wherein
the recess includes an inner surface including a bottom and a side.

5. The light emitter according to claim 3, wherein
the lid includes a first reflective film on an inner surface of the recess.

6. The light emitter according to claim 5, wherein
the first reflective film is on a bottom and a side of the inner surface.

7. The light emitter according to claim 5 or claim 6, further comprising:
a sealing metal film on a facing portion of the cladding facing the lid,
wherein the lid includes, inward from the sealing metal film on the facing portion, a second reflective film continuous with the first reflective film.

8. The light emitter according to claim 5 or claim 6, further comprising:
a sealing metal film on a facing portion of the cladding facing the lid,
wherein the lid overlaps the sealing metal film on the facing portion in a transparent plan view and includes a third reflective film continuous with the first reflective film.

9. The light emitter according to any one of claims 2 to 8, wherein
the lid is transparent, and
the lid includes a fourth reflective film on an outer surface of the lid.

10. The light emitter according to any one of claims 4 to 9, wherein
the recess includes the side sloping outward at a greater distance from the cladding.

11. The light emitter according to any one of claims 4 to 10, wherein
the inner surface of the recess is dome-shaped.

12. The light emitter according to claim 3 or claim 5, wherein
the recess includes a roughened surface included in an inner surface of the recess.

13. The light emitter according to claim 1, wherein
the light-receiving surface faces the first light-emitting element and the second light-emitting element, and
the light emitter further comprises a light diffuser between the light-receiving element and the first and second light-emitting elements.

14. The light emitter according to claim 1, further comprising:
a seal sealing the first light-emitting element, the second light-emitting element, and the light-receiving element,
wherein the element sealing area includes the seal, and
the light-receiving surface is opposite to a surface of the light-receiving element facing the first surface.

15. The light emitter according to claim 14, wherein
the seal is surrounded by the cladding in a direction along the first surface.

16. The light emitter according to claim 14, wherein
the seal is transparent, and
the seal includes a fifth reflective film on an outer surface of the seal.

17. The light emitter according to claim 15, wherein
the seal is transparent, and
the seal includes a sixth reflective film on an outer surface of the seal.

18. The light emitter according to any one of claims 14 to 17, wherein
the seal includes a roughened surface included in an outer surface of the seal.

19. The light emitter according to claim 1, further comprising:
a seal sealing the first light-emitting element, the second light-emitting element, and the light-receiving element; and
a light diffuser between the light-receiving element and the first and second light-emitting elements,
wherein the element sealing area includes the seal, and
the light-receiving surface faces the first light-emitting element and the second light-emitting element.

20. The light emitter according to any one of claims 1 to 19, further comprising:
a lens on an optical path of light emitted from the first core and the second core.
